# FASCICULE DE BREVET EUROPEEN

(11) **EP 4 060 748 B1**
(45) Date de publication et mention de la délivrance du brevet: **06.09.2023**
(21) Numéro de dépôt: 22160886.2
(22) Date de dépôt: 08.03.2022
(51) Int. Cl.: H01L 29/76, H01L 29/06, H01L 29/40, H01L 29/423, B82Y 10/00

(54) **DISPOSITIF À DEUX NIVEAUX DE GRILLES DE COMMANDE ÉLECTROSTATIQUE SUPERPOSÉS**
VORRICHTUNG MIT ZWEI ÜBEREINANDERLIEGENDEN EBENEN VON ELEKTROSTATISCHEN STEUERGITTERN
DEVICE WITH TWO LEVELS OF STACKED ELECTROSTATIC CONTROL GATES

(30) Priorité: 15.03.2021 FR 2102536
(43) Date de publication de la demande: 21.09.2022
(73) Titulaire: Commissariat à l'énergie atomique et aux énergies alternatives, 75015 Paris (FR)
(72) Inventeur: BERTRAND, Benoit, 38054 GRENOBLE CEDEX 09 (FR); MARTINEZ I DIAZ, Biel, 38054 GRENOBLE CEDEX 09 (FR); NIQUET, Yann-Michel, 38054 GRENOBLE CEDEX 09 (FR); VINET, Maud, 38054 GRENOBLE CEDEX 09 (FR)
(74) Mandataire: Brevalex

(56) Documents cités:
- WO-A1-2018/236404
- WO-A1-2019/066843
- FR-A1- 3 081 155
- US-A1- 2004 232 473
- US-A1- 2008 116 503
- US-A1- 2020 052 101
- HWANG J C C ET AL: "Impact of g-factors and valleys on spin qubits in a silicon double quantum dot", ARXIV.ORG, CORNELL UNIVERSITY LIBRARY, 201 OLIN LIBRARY CORNELL UNIVERSITY ITHACA, NY 14853, 28 août 2016 (2016-08-28), XP080722893,

## Description

### DOMAINE TECHNIQUE ET ART ANTERIEUR

L'invention concerne le domaine des dispositifs à grilles de commandes électrostatiques. L'invention s'applique notamment au domaine des dispositifs quantiques, du traitement de l'information quantique et de l'informatique quantique.

L'informatique quantique est basée sur l'utilisation d'un état quantique à deux niveaux mesurables comme vecteur d'information, appelé qubit ou bit quantique ou encore « quantum bits » en anglais, et des lois de la mécanique quantique (superposition, intrication, mesure) afin d'exécuter des algorithmes. Un dispositif quantique à un ou plusieurs qubits de spin permet de manipuler l'état quantique de ce ou ces qubits.

Les qubits de spin peuvent être formés dans du semi-conducteur, avantageusement du silicium. Les technologies semi-conductrices sont étudiées pour la réalisation de qubits en raison de leur haut potentiel d'intégration, à l'image de l'électronique classique. Des électrons ou des trous sont individuellement confinés dans des puits quantiques se trouvant dans un cryostat à des températures cryogéniques (inférieures à 4 K, voire inférieures à 1 K) réalisés au sein de structures de confinement de tailles nanométriques définies de manière électrostatique et, dans le cas du silicium, d'architecture proche de celle des MOSFETs. Ces structures de confinement correspondent à des boîtes quantiques, également appelées « quantum dots ». Une boîte quantique se comporte comme un puits de potentiel confinant une ou plusieurs charges élémentaires (électrons ou trous) dans une région de semi-conducteur.

L'application d'un champ magnétique statique (par exemple compris entre 100 mT et 1 T) permet de lever la dégénérescence de spin des quasi-particules qui est un système quantique à deux niveaux mesurables, nommés « spin down » et « spin up ». Leur état quantique est une superposition de ces deux états représentés par la direction d'une flèche au sein d'une sphère, nommée sphère de Bloch. La manipulation (rotation) de ces spins est effectuée à l'aide d'une composante alternative du champ magnétique (de fréquence par exemple comprise entre 1 GHz et plusieurs dizaines de GHz) ou à l'aide d'un champ électrique alternatif aux mêmes fréquences dans le cas d'une interaction spin-orbite suffisante (cas des trous dans du silicium) ou en présence de gradient de champ magnétique statique (par exemple intégration de micro-aimants). La lecture des spins (up ou down) permet d'extraire une partie de l'information quantique selon sa probabilité d'être dans chaque état, déterminée par la superposition quantique.

Pour contrôler de manière optimale plusieurs boîtes quantiques formées côte à côte dans une même portion de semi-conducteur, il est nécessaire de pouvoir ajuster, en plus de la profondeur de chacune des boîtes quantiques dans le semi-conducteur, c'est-à-dire le potentiel minimum de chacune des boîtes quantiques, la hauteur des barrières tunnel, ou barrières à effet tunnel, qui séparent les boîtes quantiques, et ce de manière indépendante.

Le contrôle de la hauteur des barrières tunnel et du potentiel minimum de chaque boîte quantique est réalisé par l'intermédiaire de tensions appliquées sur des grilles de contrôle électrostatique indépendantes. Les solutions proposées jusqu'à présent consistent à définir des grilles de contrôle positionnées directement au-dessus de chaque boîte quantique et de chaque barrière tunnel.

Le document de C. H. Yang et al., « Dynamically controlled charge sensing of a few-electron silicon quantum dot », AIP Advances, 1, 042111, 2011, décrit par exemple la réalisation de telles grilles en mettant en oeuvre deux ou trois cycles de lithographie successifs, avec recouvrement partiel des différents niveaux pour gérer les problèmes de désalignement. Le document de R. Pillarisetti et al., IEDM 18, propose la réalisation de telles grilles de manière auto-alignée.

Le document WO 2018/236404 A1 décrit un dispositif à points quantiques comprenant un empilement de puits quantiques, un réseau de premières lignes de grille parallèles, un réseau de secondes lignes de grille parallèles, et un réseau de troisièmes lignes de grille parallèles. Lesdites lignes de grilles sont formées au-dessus d'un puits quantique. Les secondes lignes de grille sont orientées perpendiculairement par rapport aux premières lignes de grille et les troisièmes lignes de grille sont orientées en diagonale par rapport aux premières et secondes lignes de grille. Cet arrangement permet de créer une matrice de boite quantiques dans ledit puits quantique.

Des composants électroniques à multiples îlots quantiques sont également connus des documents US 2020/052101 A1, FR 3 081 155 A1, WO 2019/066843 A1, et du document "Impact of g-factors and valleys on spin qubits in a silicon double quantum dot" (HWANG J CC ET AL, ARXIV.ORG, CORNELL UNIVERSITY LIBRARY, 201 OLIN LIBRARY CORNELL UNIVERSITY ITHACA, NY 14853, 28 août 2016).

Ces solutions ont toutefois pour inconvénient de nécessiter la réalisation des grilles de contrôle électrostatique avec une densité deux fois plus importante que celle avec laquelle les boîtes quantiques sont réalisées. Le pas de grille devant être atteint avec ces solutions est compris entre 40 nm et 60 nm, ce qui complexifie la réalisation des grilles.

Des problèmes analogues à ceux exposés ci-dessus pour les dispositifs quantiques se posent également pour d'autres types de dispositifs à grilles de commande électrostatique.

### EXPOSÉ DE L'INVENTION

Un but de la présente invention est de proposer un dispositif à grilles de commande électrostatiques dont la structure permet une réalisation plus aisée des grilles de contrôle électrostatique.

Pour cela, la présente invention propose un dispositif selon la revendication 1 comportant au moins :
- une portion de semi-conducteur comprenant plusieurs premières régions chacune disposée entre au moins deux deuxièmes régions et juxtaposée aux deux deuxièmes régions ;
- des premières grilles de commande électrostatique comprenant chacune au moins une première portion de matériau électriquement conducteur ;
- des deuxièmes grilles de commande électrostatique comprenant chacune au moins une deuxième portion de matériau électriquement conducteur et au moins un deuxième diélectrique de grille disposé entre la deuxième portion de matériau électriquement conducteur et la première portion de matériau électriquement conducteur de l'une des premières grilles de commande électrostatique, telles que chacune des premières grilles de commande électrostatique soit disposée entre la portion de semi-conducteur et l'une des deuxièmes grilles de commande électrostatique ;
dans lequel, dans une première configuration, les premières et deuxièmes grilles de commande électrostatique sont disposées au-dessus des premières régions de la portion de semi-conducteur, ou dans lequel, dans une deuxième configuration, les premières et deuxièmes grilles de commande électrostatique sont disposées au-dessus des deuxièmes régions de la portion de semi-conducteur.

Dans ce dispositif, il est proposé de réaliser des structures de grille à deux étages, ou à deux grilles distinctes superposées, dont le potentiel appliqué sur chacune des deux grilles peut être ajusté de manière indépendante l'une par rapport à l'autre.

Cette superposition des premières et deuxièmes grilles permet donc de réaliser les empilements de grilles avec un pas, ou « pitch », deux fois plus important que dans les solutions de l'art antérieur, réduisant ainsi en grande partie les difficultés liées à la réalisation des grilles de commande électrostatique.

Les deuxièmes grilles de commande électrostatique sont uniquement situées dans un prolongement vertical des premières grilles de commande électrostatique.

Les deuxièmes grilles de commande électrostatique peuvent être intégralement ou totalement localisées au-dessus d'un plan incluant les faces supérieures des premières grilles de commande électrostatique.

Dans un plan parallèle aux faces supérieures des premières grilles de commande électrostatique, la section de chaque deuxième diélectrique de grille peut avoir une forme et des dimensions similaires à celles de la section d'au moins l'une des première et deuxième portions de matériau électriquement conducteur disposée contre ledit deuxième diélectrique de grille.

Le deuxième diélectrique de grille peut ne pas être en contact avec la portion de semi-conducteur.

Le deuxième diélectrique de grille peut reposer uniquement sur les premières portions de matériau électriquement conducteur, ou uniquement sur les premières portions de matériau électriquement conducteur et une partie d'espaceurs latéraux disposés contre les premières portions de matériau électriquement conducteur.

Dans la première configuration, au moins une partie de chacune des deuxièmes régions de la portion de semi-conducteur peut ne pas être recouverte par les premières et deuxièmes grilles de commande électrostatique, et dans la deuxième configuration, au moins une partie de chacune des premières régions de la portion de semi-conducteur peut ne pas être recouverte par les premières et deuxièmes grilles de commande électrostatique.

Le dispositif peut être tel que :
- chacune des premières grilles de commande électrostatique comporte en outre au moins un premier diélectrique de grille disposé entre la portion de semi-conducteur et la première portion de matériau électriquement conducteur de ladite première grille de commande électrostatique, ou
- le dispositif comporte un empilement de plusieurs semi-conducteurs différents formant une hétérostructure et incluant la portion de semi-conducteur, et tel que des interfaces entre l'empilement de plusieurs semi-conducteurs et les premières portions de matériau électriquement conducteur des premières grilles de commande électrostatique forment des barrières Schottky, ou
- le dispositif peut être tel que chacune des premières grilles de commande électrostatique comporte en outre au moins un premier diélectrique de grille disposé entre un empilement de plusieurs semi-conducteurs et la première portion de matériau électriquement conducteur, l'empilement de plusieurs semi-conducteurs comportant des semi-conducteurs différents formant une hétérostructure.

Le semi-conducteur des premières et deuxièmes régions peut être non intentionnellement dopé.

De manière avantageuse :
- le dispositif est un dispositif quantique ;
- les premières régions de la portion de semi-conducteur sont configurées pour former des boîtes quantiques d'au moins un qubit de spin du dispositif ;
- les deuxièmes régions de la portion de semi-conducteur sont configurées pour former des barrières tunnel entre lesquelles sont disposées les boîtes quantiques.

Dans la première configuration, du fait que les structures de grille à deux étages sont localisées au-dessus des boîtes quantiques, les potentiels électriques appliqués sur les premières grilles de contrôle électrostatique vont permettre de contrôler principalement les potentiels minimums des boîtes quantiques formées dans les premières régions de la portion de semi-conducteur localisées sous les premières grilles. De plus, les potentiels électriques appliqués sur les deuxièmes grilles de contrôle électrostatique vont permettre de contrôler principalement les hauteurs des barrières tunnel formées dans les deuxièmes régions de la portion de semi-conducteur, du fait que les premières grilles forment des écrans vis-à-vis des champs électriques créés par les deuxièmes grilles.

Dans la deuxième configuration, du fait que les structures de grille à deux étages sont localisées au-dessus des barrières tunnel, les potentiels électriques appliqués sur les premières grilles de contrôle électrostatique vont permettre de contrôler principalement les hauteurs des barrières tunnel formées dans les deuxièmes régions de la portion de semi-conducteur localisées sous les premières grilles, et les potentiels électriques appliqués sur les deuxièmes grilles de contrôle électrostatique vont permettre de contrôler principalement les potentiels minimums des puits quantiques formés dans les premières régions de la portion de semi-conducteur.

Le dispositif quantique peut être utilisé avec des spins de trous et/ou des spins d'électrons.

Dans ce dispositif quantique, les diélectriques de grille ne correspondent pas à des oxydes tunnel, c'est-à-dire ne permettent pas le passage des charges par effet tunnel à travers eux.

Le dispositif peut comporter en outre des réservoirs de porteurs de charges électriques entre lesquels les premières et deuxièmes régions de la portion de semi-conducteur sont disposées. Ces réservoirs de porteurs de charges électriques peuvent correspondre à des parties dopées de la portion de semi-conducteur, et les premières et deuxièmes régions peuvent comporter du semi-conducteur non intentionnellement dopé (nid).

Le dispositif peut être tel que :
- les premières portions de matériau électriquement conducteur ont chacune une épaisseur comprise entre 5 nm et 30 nm ;
- les deuxièmes diélectriques de grille ont chacun une épaisseur comprise entre 2 nm et 15 nm ;
- des deuxièmes portions de matériau électriquement conducteur ont chacune une épaisseur comprise entre 5 nm et 40 nm.

Lorsque les premières grilles de commande électrostatique comportent chacune un diélectrique de grille, les premiers diélectriques de grille peuvent avoir chacun une épaisseur comprise entre 2 nm et 10 nm.

Le dispositif peut comporter en outre des moyens d'application d'au moins un premier potentiel électrique sur chacune des premières portions de matériau électriquement conducteur et d'au moins un deuxième potentiel électrique, de valeur indépendante de celle du premier potentiel électrique, sur chacune des deuxièmes portions de matériau électriquement conducteur. Ces moyens d'application peuvent comporter notamment des contacts électriques qui sont reliés aux premières et deuxièmes portions de matériau électriquement conducteur, ainsi que les éléments permettant d'amener les potentiels électriques souhaités sur ces contacts électriques.

Le dispositif peut être tel que les premières et deuxièmes régions de la portion de semi-conducteur soient alignées selon une première direction, ou parallèlement à la première direction, et :
- une dimension, parallèle à la première direction, d'au moins l'une des premières portions de matériau électriquement conducteur est inférieure à une dimension, parallèle à la première direction, de la deuxième portion de matériau électriquement conducteur disposée sur ladite au moins une des premières portions de matériau électriquement conducteur, ou
- une dimension, parallèle à la première direction, d'au moins l'une des deuxièmes portions de matériau électriquement conducteur est inférieure à une dimension, parallèle à la première direction, de la première portion de matériau électriquement conducteur disposée sous ladite au moins une des deuxièmes portions de matériau électriquement conducteur.

Ces variantes de réalisation des grilles de commande électrostatique permettent d'ajuster les effets de l'une des grilles par rapport à l'autre en réalisant l'une des premières et deuxièmes grilles avec une largeur différente de celle de l'autre grille. Dans le premier cas, en réduisant la largeur de la première grille, la partie de la portion de semi-conducteur contrôlée par la deuxième grille a donc des dimensions plus importantes. Dans le deuxième cas, en augmentant la largeur de la première grille par rapport à celle de la deuxième grille, la partie de la portion de semi-conducteur contrôlée par la première grille a des dimensions plus importantes.

Le dispositif peut être tel que :
- chacune des premières et deuxièmes portions de matériau électriquement conducteur comporte une plus grande dimension s'étendant selon une deuxième direction perpendiculaire à la première direction, et
- au moins une extrémité de chacune des premières portions de matériau électriquement conducteur n'est pas recouverte par la deuxième portion de matériau électriquement conducteur disposée sur ladite première portion de matériau électriquement conducteur, et
- chacune des premières portions de matériau électriquement conducteur est couplée électriquement à un premier contact électriquement conducteur réalisé sur ladite extrémité de chacune des premières portions de matériau électriquement conducteur, et
- chacune des deuxièmes portions de matériau électriquement conducteur est couplée électriquement à un deuxième contact électriquement conducteur réalisé sur la deuxième portion de matériau électriquement conducteur.

Cette configuration avantageuse permet de contacter aisément les premières grilles qui sont disposées sous les deuxièmes grilles.

Dans ce cas, le dispositif peut être tel que :
- des première et deuxième extrémités de chacune des premières portions de matériau électriquement conducteur ne sont pas recouvertes par la deuxième portion de matériau électriquement conducteur disposée sur ladite première portion de matériau électriquement conducteur, et
- chacune des premières portions de matériau électriquement conducteur est couplée électriquement à un premier contact électriquement conducteur réalisé sur l'une des première et deuxième extrémités de chacune des premières portions de matériau électriquement conducteur, et deux des premiers contacts électriquement conducteurs couplés électriquement à deux des premières portions de matériau électriquement conducteur disposées côte à côte sont tels que l'un desdits deux premiers contacts électriquement conducteurs soit réalisé sur la première extrémité de l'une desdites deux des premières portions de matériau électriquement conducteur et que l'autre desdits deux premiers contacts électriquement conducteurs soit réalisé sur la deuxième extrémité de l'autre desdites deux des premières portions de matériau électriquement conducteur.

Cette configuration avantageuse permet de répartir les premiers contacts électriquement conducteurs des premières grilles sur les premières et deuxièmes extrémités des premières portions de matériau électriquement conducteur, de manière alternée, ce qui permet de réduire les contraintes liées aux dimensions des premiers contacts électriquement conducteurs qui peuvent être plus importantes que lorsque les premiers contacts électriquement conducteurs sont réalisés les uns à côté des autres sur des extrémités des premières portions localisés toutes du même côté.

La portion de semi-conducteur peut correspondre à un nanofil de semi-conducteur. Un nanofil de semi-conducteur correspond à une portion de semi-conducteur dont le diamètre ou l'épaisseur est nanométrique et dont la géométrie permet un confinement unidimensionnel de charges grâce à la commande électrostatique des grilles du dispositif.

Dans un deuxième mode de réalisation, le dispositif peut être tel que :
- la portion de semi-conducteur comporte une face supérieure, une face inférieure et des faces latérales sensiblement perpendiculaires aux faces supérieure et inférieure ;
- chacune des premières et deuxièmes grilles de commande recouvre partiellement au moins une des première et deuxième arrêtes supérieures de la portion de semi-conducteur formées aux jonctions entre la face supérieure et des première et deuxième faces latérales opposées l'une de l'autre et parallèle à la plus grande dimension de la portion de semi-conducteur.

Dans cette configuration, les premières régions de semi-conducteur peuvent être formées sous les arrêtes supérieures de la portion de semi-conducteur.

En outre, dans ce cas, le dispositif peut être tel que :
- plusieurs des premières et deuxièmes grilles de commande recouvrent partiellement la première arrête supérieure et les autres premières et deuxièmes grilles de commande recouvrent partiellement la deuxième arrête supérieure, chacune des premières et deuxièmes grilles de commande recouvrant partiellement la première arrête supérieure étant disposée en regard d'une première et d'une deuxième grille de commande recouvrent partiellement la deuxième arrête supérieure ;
et comportant en outre une troisième grille de commande électrostatique comprenant au moins une troisième portion de matériau électriquement conducteur disposée en regard d'au moins une quatrième région de la portion de semi-conducteur non recouverte par les premières et deuxièmes grilles de commande électrostatique.

Dans le cas d'un dispositif quantique, la quatrième région de la portion de semi-conducteur peut former des deuxièmes barrières tunnel séparant chacune deux des boîtes quantiques formées au niveau des deux arrêtes supérieures.

Dans cette configuration, un arrangement de plusieurs boîtes quantiques disposées deux à deux en regard l'une de l'autre le long du nanofil peut être obtenu. Ainsi, un nombre deux fois plus important de boîtes quantiques peuvent être formées dans le nanofil de semi-conducteur.

Dans un troisième mode de réalisation, les premières régions de la portion de semi-conducteur peuvent être agencées sous la forme d'une matrice bidimensionnelle, plusieurs des premières et deuxièmes grilles de commande électrostatique étant agencées sous la forme de lignes et les autres premières et deuxièmes grilles de commande étant agencées sous la forme de colonnes.

Dans ce troisième mode de réalisation, la portion de semi-conducteur peut correspondre à une couche de semi-conducteur d'épaisseur nanométrique ou à un réseau de nanofils se croisant en formant une matrice.

La portion de semi-conducteur peut être disposée sur une couche diélectrique enterrée d'un substrat de type semi-conducteur sur isolant.

Le dispositif peut comporter en outre des espaceurs diélectriques recouvrant des flancs latéraux des premières et deuxièmes grilles de commande électrostatique, et disposés, dans la première configuration, au-dessus des deuxièmes régions de la portion de semi-conducteur, ou, dans la deuxième configuration, au-dessus des première régions de la portion de semi-conducteur.

Les espaceurs diélectriques peuvent comporter au moins un premier matériau diélectrique recouvrant les flancs latéraux des premières portions de matériau électriquement conducteur et au moins un deuxième matériau diélectrique recouvrant les flancs latéraux des deuxièmes portions de matériau électriquement conducteur, la permittivité du premier matériau diélectrique étant inférieure à celle du deuxième matériau diélectrique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent schématiquement différentes vues d'un dispositif selon un premier mode de réalisation ;
- les figures 4 à 6 représentent schématiquement des variantes de réalisation du dispositif selon le premier mode de réalisation ;
- les figures 7 et 8 représentent schématiquement deux configurations du dispositif selon le premier mode de réalisation ;
- la figure 9 représente schématiquement un dispositif selon un deuxième mode de réalisation ;
- les figures 10 à 13 représentent schématiquement différentes vues d'un dispositif selon un troisième mode de réalisation ;
- les figures 14 à 26 représentent schématiquement les étapes d'un procédé de réalisation d'un dispositif selon le premier mode de réalisation ;
- la figure 27 représente les étapes mises en oeuvre pour la réalisation d'espaceurs diélectriques comportant des matériaux différents.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

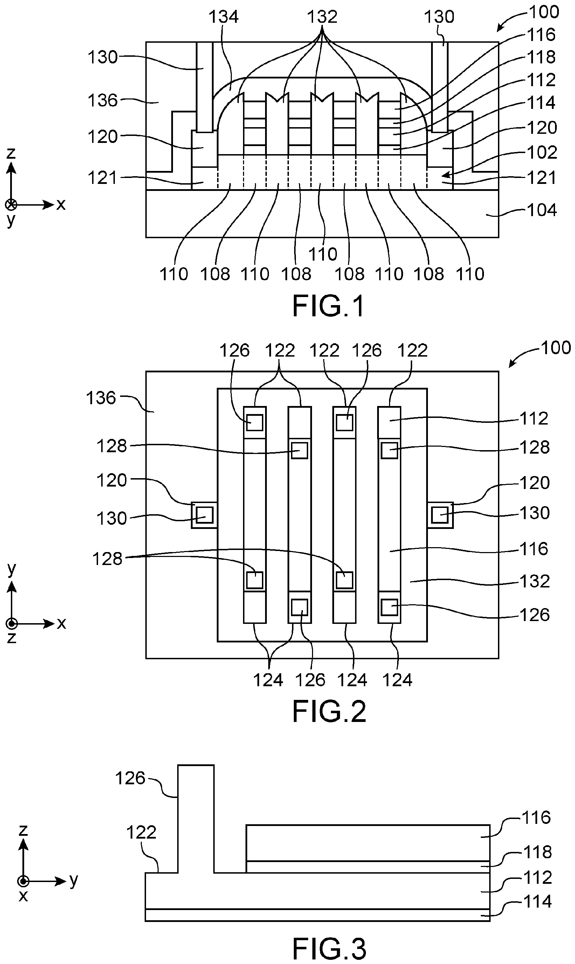

Un dispositif 100 à grilles de commande électrostatique superposées selon un premier mode de réalisation est décrit ci-dessous en lien avec les figures 1 à 3. Dans l'exemple de réalisation décrit ci-dessous, le dispositif 100 correspond à un dispositif quantique à qubits de spin.

Le dispositif 100 comporte une portion de semi-conducteur 102. Le semi-conducteur de la portion 102 correspond par exemple à du silicium, ou en variante à du GaAs.

La portion 102 est par exemple disposée sur une couche diélectrique 104 qui peut comporter du SiO₂.

Avantageusement, la portion 102 correspond à une partie d'une couche superficielle d'un substrat de type semi-conducteur sur isolant, par exemple SOI (« Silicon-On-Insulator » en anglais, ou silicium sur isolant). La couche diélectrique 104 correspond dans ce cas à la couche diélectrique enterrée, ou BOX (« Buried-Oxide » en anglais), de ce substrat.

Dans l'exemple de réalisation décrit ici, la portion 102 correspond à un nanofil comprenant les caractéristiques suivantes :
- épaisseur (dimension selon l'axe Z) comprise entre environ 5 nm et 20 nm ;
- largeur (dimension selon l'axe Y) comprise entre environ 20 nm et 80 nm ;
- longueur (dimension selon l'axe X) fonction du nombre de boîtes quantiques formées dans la portion 102, et comprise entre environ 60 nm à 120 nm par boîte quantique. Sur l'exemple des figures 1 à 3 où quatre boîtes quantiques sont formées dans la portion 102, la longueur de la portion 102 est comprise entre environ 350 nm et 650 nm.

Le dispositif 100 comporte plusieurs qubits réalisés côte à côte dans la portion 102. Chacun de ces qubits comprend une boîte quantique formée dans une première région 108 de la portion 102 et disposée entre deux barrières tunnel formées par des deuxièmes régions 110 de la portion 102. Sur la figure 1, les premières régions 108 sont délimitées symboliquement des deuxièmes régions 110 par des traits pointillés. Les premières et deuxièmes régions 108, 110 de la portion 102 comportent du semi-conducteur non intentionnellement dopé (nid).

Le dispositif 100 comporte des premières grilles de commande électrostatique comprenant chacune au moins une première portion de matériau électriquement conducteur 112 et au moins un premier diélectrique de grille 114 disposé entre la portion 102 et la première portion de matériau électriquement conducteur 112. Dans l'exemple de réalisation décrit ici, les premiers diélectriques de grille 114 ont chacun une épaisseur comprise entre 2 nm et 10 nm, par exemple égale 5 nm, et comportent du SiOz et/ou du HfOz et/ou de l'Al₂O₃. Les premières portions 112 ont chacune une épaisseur comprise entre 5 nm et 30 nm, par exemple égale à 10 nm, et comportent du polysilicium dopé dégénéré et/ou du TiN et/ou W.

Le dispositif 100 comporte également des deuxièmes grilles de commande électrostatique disposées sur les premières grilles. Ces deuxièmes grilles comportent chacune au moins une deuxième portion 116 de matériau électriquement conducteur et au moins un deuxième diélectrique de grille 118 disposé entre la deuxième portion 116 et la première portion 112 sur laquelle la deuxième grille est disposée. Ainsi, chacune des premières grilles est disposée entre la portion de semi-conducteur 102 et l'une des deuxièmes grilles. Dans l'exemple de réalisation décrit ici, les deuxièmes diélectriques de grille 118 ont chacun une épaisseur comprise entre 2 nm et 15 nm, par exemple égale à 10 nm, et comportent du SiOz et/ou du HfOz et/ou de l'Al₂O₃, et les deuxièmes portions 116 ont chacune une épaisseur comprise entre 5 nm et 40 nm, par exemple égale à 20 nm, et comportent du polysilicium dopé dégénéré et/ou du TiN et/ou du W.

Dans l'exemple de réalisation décrit ici, les premières et deuxièmes grilles sont disposées au-dessus des premières régions 108 de la portion 102.

Comme cela est visible sur la figure 1, les deuxièmes grilles sont uniquement situées dans le prolongement vertical des premières grilles (le terme « vertical » désignant la direction perpendiculaire au plan principal de la portion 102 ou perpendiculaire au plan de la face la portion 102 sur laquelle les premières grilles sont disposées).

Les deuxièmes grilles de commande électrostatique sont intégralement ou totalement localisées au-dessus d'un plan incluant les faces supérieures des premières grilles de commande.

Dans un plan parallèle aux faces supérieures des premières grilles de commande, la section de chaque deuxième diélectrique de grille 118 a une forme et des dimensions similaires à celles de la section d'au moins l'une des première et deuxième portions de matériau électriquement conducteur 112, 116 disposées contre ledit deuxième diélectrique de grille 118.

Le deuxième diélectrique de grille 118 n'est pas en contact avec la portion 102.

Dans la configuration visible sur la figure 1, le deuxième diélectrique de grille 118 repose uniquement sur les premières portions de matériau électriquement conducteur 112.

Le dispositif 100 comporte également des réservoirs 120 de porteurs de charges électriques entre lesquels les premières et deuxièmes régions 108, 110 sont disposées. Dans l'exemple de réalisation décrit ici, les réservoirs 120 correspondent à des portions de semi-conducteur dopé formé par épitaxie sur des extrémités 121 de la portion 102. En variante, ces réservoirs 120 peuvent correspondre aux extrémités 121 de la portion 102 dans lesquelles des dopants sont directement implantés.

Les premières et deuxièmes régions 108, 110 sont ici alignées selon une première direction qui est parallèle à la longueur du nanofil formé par la portion 102 (parallèle à l'axe X sur les figures 1 et 2).

Bien que non visibles sur les figures 1 à 3, le dispositif 100 comporte également des moyens d'application d'un premier potentiel électrique sur chacune des premières portions 112 et d'un deuxième potentiel électrique, de valeur indépendante de celle du premier potentiel électrique, sur chacune des deuxièmes portions 116.

Afin de pouvoir accéder électriquement aux premières grilles qui se trouvent sous les deuxièmes grilles, au moins une des extrémités de chacune des premières portions 112 n'est pas recouverte par les deuxièmes diélectriques de grille 118 et les deuxièmes portions 116. Sur l'exemple de réalisation représenté sur les figures 1 à 3, les premières extrémités 122 et les deuxièmes extrémités 124 des premières portions 112 ne sont pas recouvertes par les deuxièmes diélectriques de grille 118 et les deuxièmes portions 116. De plus, chacune des premières portions 112 est couplée électriquement à un premier contact électriquement conducteur 126 réalisé sur l'une des extrémités 122, 124 de chacune des premières portions 112, et chacune des deuxièmes portions 116 est couplée électriquement à un deuxième contact électriquement conducteur 128 réalisé sur chacune des deuxièmes portions 116. La figure 3 représente une première extrémité 122 d'une des premières portions 112 qui n'est pas recouverte par la deuxième grille disposée sur cette première portion 112 et qui forme un emplacement pour l'un des premiers contacts 126.

De manière avantageuse, et comme c'est le cas dans la configuration visible sur la figure 2, chacune des premières portions 112 est couplée électriquement à un premier contact 126 réalisé sur l'une des première et deuxième extrémités 122, 124 de la première portion 112, et deux des premiers contacts 126 couplés électriquement à deux des premières portions 112 disposées côte à côte sont tels que l'un desdits deux premiers contacts 126 soit réalisé sur la première extrémité 122 de l'une desdites deux des premières portions 112 et que l'autre desdits deux premiers contacts 126 soit réalisé sur la deuxième extrémité 124 de l'autre desdites deux des premières portions 112. Ainsi, les premiers contacts 126 sont disposés alternativement sur les premières et deuxièmes extrémités 122, 124 des premières portions 112, le long de la portion 102. Etant donné que le pas, ou « pitch », avec lequel les premières et deuxièmes grilles sont réalisées selon la première direction dépend notamment des dimensions des premiers contacts 126 dans le plan (X, Y) (plan parallèle aux interfaces entre la portion 102 et les premiers diélectriques de grilles 114), cette disposition alternée des premiers contacts 126 sur les premières et deuxièmes extrémités 122, 124 permet de réduire ce pas, et donc la distance séparant deux premières grilles voisines. Selon un exemple de réalisation, le pas avec lequel les premières et deuxièmes grilles de commande électrostatique sont réalisées est par exemple égal à 80 nm, chaque empilement d'une première et d'une deuxième grilles ayant une dimension, selon la première direction, égale à 40 nm et est espacé d'un empilement voisin d'autres première et deuxième grilles d'une distance, selon la première direction, égale à 40 nm. Avantageusement, le pas avec lequel les premières et deuxièmes grilles sont réalisées est compris entre 60 nm et 120 nm.

Le dispositif 100 comporte également des troisièmes contacts électriquement conducteurs 130 réalisés sur les réservoirs 120.

Les contacts 126, 128, 130 comportent par exemple au moins un métal tel que par exemple du Ti, du TiN ou du W.

Le dispositif 100 comporte également des espaceurs diélectriques 132 recouvrant des flancs latéraux des premières et deuxièmes grilles. Les espaceurs diélectriques 132 comportent par exemple du SiO₂. Dans la configuration de la figure 1 où les premières et deuxièmes grilles sont disposées au-dessus des premières régions 108, les espaceurs diélectriques 132 sont disposés au-dessus des deuxièmes régions 110. Si les premières et deuxièmes grilles étaient disposées au-dessus des deuxièmes régions 110, les espaceurs diélectriques 132 seraient disposés au-dessus des premières régions 108.

Tous les éléments du dispositif 100 précédemment décrits autres que les contacts 126, 128 et 130 sont recouverts d'une couche d'arrêt à la gravure 134, comportant par exemple du SiN. L'ensemble est recouvert d'un matériau diélectrique pré-métal 136, comportant par exemple du SiOz et dont la surface supérieure est planarisée et à travers lequel les contacts 126, 128 et 130 sont réalisés. Sur la figure 2, les parties de la couche d'arrêt à la gravure 134 et du matériau diélectrique pré-métal 136 se trouvant au-dessus des grilles et des espaceurs diélectriques 132 ne sont pas représentées afin d'avoir une vue de dessus des grilles et des espaceurs diélectriques 132.

Ainsi, le dispositif 100 comporte, au niveau de chaque qubit, une structure de grille à deux étages, ou à deux grilles distinctes superposées, le potentiel électrique de polarisation appliqué sur chacune des deux grilles pouvant être ajusté de manière indépendante l'une par rapport à l'autre. Du fait que, dans l'exemple de réalisation décrit ici, les structures de grille à deux étages sont localisées au-dessus des boîtes quantiques, les potentiels électriques appliqués sur les premières grilles vont permettre de contrôler les potentiels minimums des boîtes quantiques formées dans les premières régions 108 localisées sous les premières grilles, et les potentiels électriques appliqués sur les deuxièmes grilles vont permettre de contrôler les niveaux des barrières tunnel formées dans les deuxièmes régions 110. Du fait que les premières grilles forment des écrans vis-à-vis des champs électriques créés par les deuxièmes grilles, ces champs vont donc servir à contrôler non pas les potentiels minima des boîtes quantiques formées dans les premières régions 108, mais à contrôler les niveaux des barrières tunnel dans les deuxièmes régions 110 non recouvertes par les premières grilles.

Pour les barrières tunnel qui sont localisées entre deux puits quantiques, le niveau de chacune de ces barrières tunnel est contrôlé par l'intermédiaire des deux deuxièmes grilles localisées au-dessus des deux puits quantiques adjacents à la barrière tunnel.

Le champ généré par chacune des premières grilles va avoir tout de même une influence sur les niveaux des barrières tunnel adjacentes à la boîte quantique contrôlée par chacune des premières grilles. De plus, le champ électrique généré par chacune des deuxièmes grilles a également une influence sur le potentiel minimum du puits quantique présent sous chacune des deuxièmes grilles. Ainsi, les valeurs des potentiels électriques à appliquer sur chacune des premières et deuxièmes grilles sont choisies en tenant compte de l'influence des autres grilles présentes au voisinage de celle-ci.

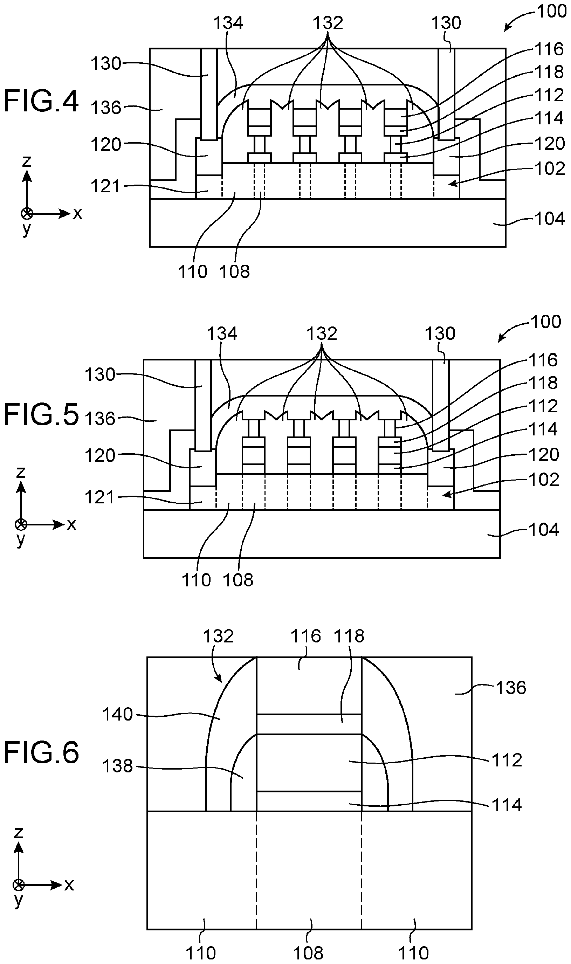

La figure 4 représente le dispositif 100 selon une première variante de réalisation. Dans cette première variante, la dimension de chacune des premières portions 112 qui est parallèle à la première direction (direction d'alignement des premières et deuxièmes régions 108, 110, parallèle à l'axe X sur la figure 4) est inférieure à cette même dimension de chacune des deuxièmes portions 116. Cela a notamment pour effet de réduire la dimension, selon cette première direction, des boîtes quantiques formées sous les premières portions 112, c'est-à-dire des premières régions 108, et d'augmenter la dimension, selon cette première direction, des barrières tunnel correspondant aux deuxièmes régions 110. En outre, dans cette première variante, les deuxièmes diélectriques de grille 118 reposent uniquement sur les premières portions de matériau électriquement conducteur 112 et une partie des espaceurs latéraux 132 disposés contre les premières portions de matériau électriquement conducteur 112.

La figure 5 représente le dispositif 100 selon une deuxième variante de réalisation. Dans cette deuxième variante, la dimension de chacune des premières portions 112 qui est parallèle à la première direction (direction d'alignement des premières et deuxièmes régions 108, 110, parallèle à l'axe X sur la figure 4) est supérieure à cette même dimension de chacune des deuxièmes portions 116. Cela a notamment pour effet d'augmenter la dimension, selon cette première direction, des boîtes quantiques formées sous les premières portions 112, c'est-à-dire des premières régions 108, et de réduire la dimension, selon cette première direction, des barrières tunnel correspondant aux deuxièmes régions 110.

Ces deux variantes de réalisation permettent d'ajuster les effets des premières et deuxièmes grilles les unes par rapport aux autres, en fonction des valeurs des potentiels minimums souhaités pour les boîtes quantiques et des niveaux des barrières tunnel formées dans la portion 102.

Dans les dispositifs 100 précédemment décrits en lien avec les figures 1 à 5, les espaceurs diélectriques 132 recouvrant les flancs latéraux des premières et deuxièmes grilles comportent un seul matériau diélectrique. En variante, il est possible que ces espaceurs diélectriques 132 comportent au moins un premier matériau diélectrique recouvrant les flancs latéraux des premières portions 112 et au moins un deuxième matériau diélectrique recouvrant les flancs latéraux des deuxièmes portions 116. La figure 6 représente schématiquement une telle configuration, dans laquelle les espaceurs diélectriques 132 comportent une première partie 138 comprenant un premier matériau diélectrique recouvrant les flancs latéraux des premières portions 112 et une deuxième partie 140 comprenant un deuxième matériau diélectrique recouvrant les flancs latéraux des deuxièmes portions 116. Sur le schéma de la figure 6, la première partie 138 des espaceurs diélectriques 132 recouvre également les flancs latéraux du premier diélectrique de grille 114 et la deuxième partie 140 des espaceurs diélectriques 132 recouvre également les flancs latéraux du deuxième diélectrique de grille 118. Dans cette variante, la permittivité du premier matériau diélectrique de la première partie 138 est avantageusement inférieure à celle du deuxième matériau diélectrique de la deuxième partie 140. Le premier matériau diélectrique est par exemple un matériau dit « Low-k », comme par exemple du SiOz, et le deuxième matériau diélectrique est par exemple un matériau dit « High-k », comme par exemple du SiN.

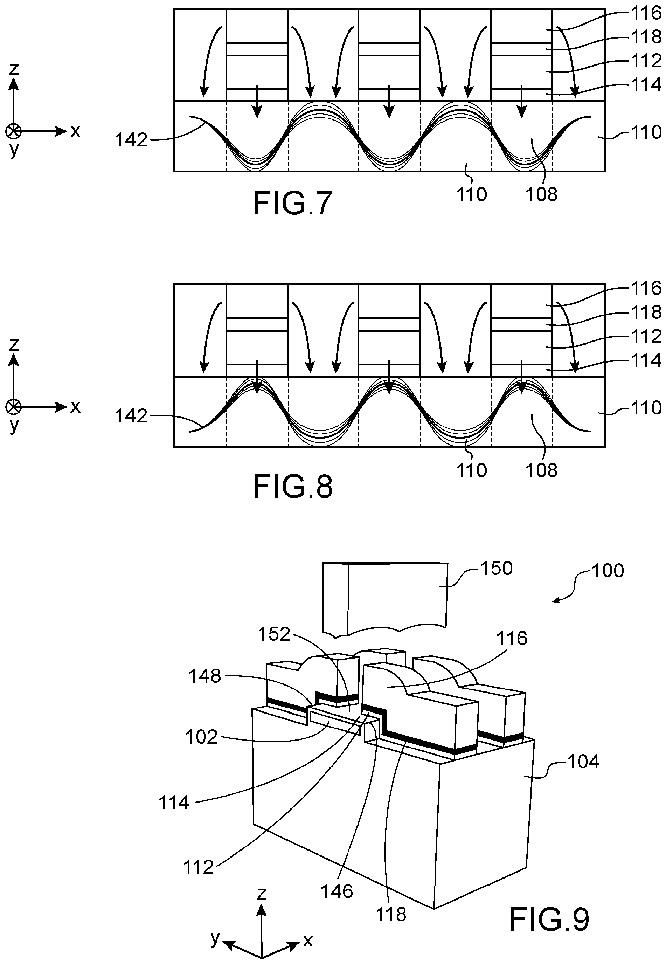

Dans les dispositifs 100 précédemment décrits, les premières et deuxièmes grilles sont disposées au-dessus des premières régions 108 dans lesquelles sont formées les boîtes quantiques. La figure 7 représente schématiquement cette première configuration, sur laquelle la courbe référencée 142 représente symboliquement le potentiel obtenu dans les premières et deuxièmes régions 108, 110 via les champs électriques appliqués par les premières et deuxièmes grilles.

Dans une deuxième configuration, il est possible que les premières et deuxièmes grilles soient disposées au-dessus des deuxièmes régions 110 qui forment les barrières tunnel. Dans ce cas, les potentiels électriques appliqués sur les premières grilles permettent de contrôler le niveau des barrières tunnel formées dans les deuxièmes régions 110, et les potentiels électriques appliqués sur les deuxièmes grilles permettent de contrôler les potentiels minimums des puits quantiques formés dans les premières régions 108. Le niveau de chaque puits quantique est contrôlé par l'intermédiaire des deux deuxièmes grilles localisées au-dessus des deux barrières tunnel adjacentes au puits quantique. La figure 8 représente schématiquement cette deuxième configuration.

Etant donné que les premières et deuxièmes régions 108, 110 comportent un matériau similaire, le fait que le dispositif 100 se retrouve dans l'une ou l'autre de ces deux configurations dépend des valeurs des potentiels électriques appliqués sur les premières et deuxièmes portions 112, 116.

Dans le cas où des électrons sont confinés dans les boîtes quantiques, et relativement aux travaux de sorties des différents matériaux en présence, des tensions plus positives (respectivement négatives) sur les premières (respectivement deuxièmes) grilles engendreront la première configuration, alors que des tensions plus négatives (respectivement positives) sur les premières (respectivement deuxièmes) grilles engendreront la deuxième configuration. Dans le cas de boîtes quantiques confinant des trous et non des électrons, les polarisations des tensions indiquées ci-dessus sont inversées.

Un dispositif 100 selon un deuxième mode de réalisation est décrit ci-dessous en lien avec la figure 9.

Dans ce deuxième mode de réalisation, chacune des premières et deuxièmes grilles ne recouvre pas la portion 102 sur toute la largeur de la portion 102, mais uniquement sur une partie de cette largeur afin de recouvrir une des arrêtes supérieures 146, 148 de la portion 102, l'autre arrête supérieure de la portion 102 étant recouverte par d'autres premières et deuxièmes grilles de commande électrostatique. Avec de telles grilles de commande, des boîtes quantiques sont donc formées sous chacune des arrêtes supérieures 146, 148 de la portion 102, ce qui permet, par rapport au premier mode de réalisation, de doubler le nombre de boîtes quantiques pouvant être obtenues dans la portion 102. Les boîtes quantiques localisées l'une en face de l'autre sous les deux arrêtes supérieures 146, 148 sont séparées par une barrière tunnel dont le potentiel est contrôlé par une troisième grille de commande électrostatique comprenant au moins une troisième portion de matériau électriquement conducteur 150 et au moins un troisième diélectrique de grille disposé entre la portion 102 et la troisième portion 150. Cette troisième grille est disposée en regard d'une quatrième région 152 de la portion 102 qui n'est pas recouverte par les premières et deuxièmes grilles et dans laquelle sont formées les barrières tunnel séparant chacune des deux boîtes quantiques formées sous les deux arrêtes supérieures 146, 148. Dans l'exemple de réalisation représenté sur la figure 9, le premier diélectrique de grille 114 et le troisième diélectrique de grille sont formés par une même couche de matériau diélectrique recouvrant la portion 102. Sur l'exemple de la figure 9, la troisième portion 150 repose sur tout ou partie de la couche d'arrêt à la gravure 134 (non représentée sur la figure 9 pour des raisons de clarté de cette figure) ainsi que sur d'éventuels espaceurs diélectriques (également non représentés sur la figure 9 pour des raisons de clarté de cette figure).

Comme dans le premier mode de réalisation, les valeurs des potentiels électriques à appliquer sur chacune des premières et deuxièmes grilles et sur la troisième grille seront choisies en tenant compte de l'influence des autres grilles présentes au voisinage de celle-ci.

Des caractéristiques détaillées d'un exemple de réalisation du dispositif 100 selon ce deuxième mode de réalisation sont données ci-dessous :
- portion 102 formée par un nanofil de silicium ayant une épaisseur (dimension selon l'axe Z) égale à 10 nm, une largeur (dimension selon l'axe Y) égale à 80 nm et une longueur (dimension selon l'axe X) égale à 140 nm ;
- couche diélectrique 104 d'épaisseur égale à 145 nm ;
- premières portions 112 comportant du TiN et une épaisseur égale à 5 nm ;
- premiers diélectriques de grille 114 comportant du SiOz et une épaisseur égale à 5 nm ;
- deuxièmes portions 116 comportant du polysilicium et une épaisseur égale à 40 nm ;
- deuxièmes diélectriques de grille 118 comportant du SiOz et une épaisseur égale à 5 nm ;
- espacement entre deux premières et deux deuxièmes grilles disposées côte à côte sur une même arrête supérieure de la portion 102 égal à 40 nm ;
- espacement entre deux premières et deux deuxièmes grilles disposées l'une en face de l'autre et qui recouvrent deux arrêtes supérieures différentes égal à 40 nm ;
- espacement entre la portion 102 et la troisième grille 150 compris entre 85 nm et 90 nm ;
- épaisseur de la troisième grille 150 égale à 65 nm ;
- largeur (dimension selon l'axe Y) de la troisième grille 150 égale à 40 nm.

Les différentes variantes de réalisation et autres caractéristiques précédemment décrites pour le premier mode de réalisation peuvent s'appliquer au dispositif 100 selon le deuxième mode de réalisation.

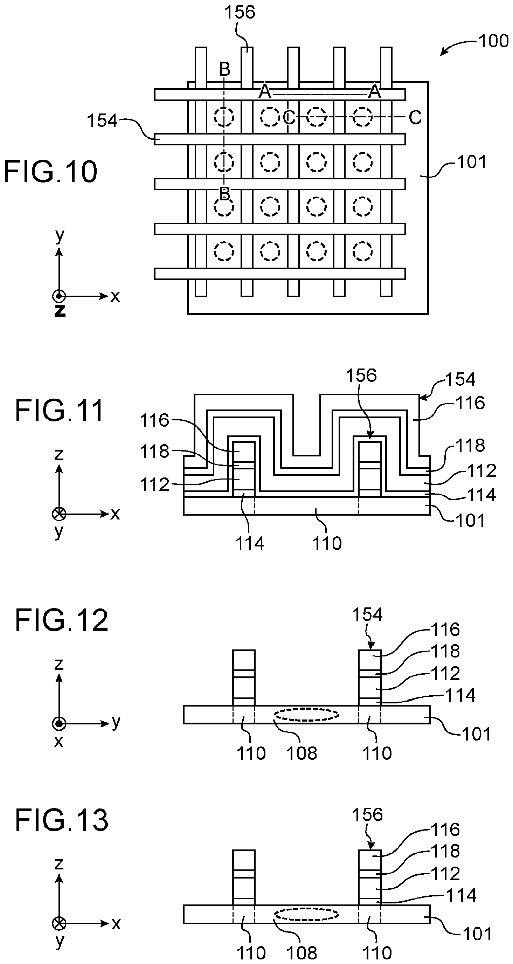

Un dispositif 100 selon un troisième mode de réalisation est décrit ci-dessous en lien avec les figures 10 à 13. La figure 10 correspond à une vue de dessus du dispositif 100. Les figures 11 à 13 correspondent à des vues en coupe respectivement selon les axes AA, BB et CC (visibles sur la figure 10) d'une partie du dispositif 100.

Dans ce troisième mode de réalisation, les qubits sont agencés sous la forme d'une matrice bidimensionnelle de boîtes quantiques. Contrairement aux précédents modes de réalisation, les boîtes quantiques ne sont pas réalisées dans un nanofil de semi-conducteur, mais dans une portion de semi-conducteur correspondant à une couche de semi-conducteur 101 ou à un réseau de nanofils se croisant en formant une matrice.

Plusieurs des premières et deuxièmes grilles de commande électrostatique sont agencées sous la forme de lignes et portent la référence 154, et d'autres premières et deuxièmes grilles sont agencées sous la forme de colonnes qui portent la référence 156 et qui se superposent aux lignes de grilles 154 aux intersections entre les lignes et colonnes de grilles.

Dans ce troisième mode de réalisation, les boîtes quantiques sont formées dans les régions de la portion 102 qui ne sont pas recouvertes par les premières et deuxièmes grilles. Ces puits quantiques sont symboliquement représentés, sur la figure 10, par des ronds pointés. Ainsi, les premières grilles (premières portions 112 + premiers diélectriques de grille 114) des lignes 154 et des colonnes 156 servent principalement à définir les potentiels des barrières tunnel et les deuxièmes grilles (deuxièmes portions 116 + deuxièmes diélectriques de grille 118) servent principalement à définir les potentiels minimums des boîtes quantiques.

Les différentes variantes de réalisation et autres caractéristiques précédemment décrites pour le premier mode de réalisation peuvent s'appliquer au dispositif 100 selon le troisième mode de réalisation.

Dans tous les modes de réalisation et variantes précédemment décrits, il est possible que la portion de semi-conducteur 102 fasse partie d'un empilement de plusieurs semi-conducteurs différents formant une hétérostructure. Une telle hétérostructure correspond par exemple à un empilement alterné de couches de Si et de SiGe, ou de couches de GaAs et d'AlGaAs, ou de Ge et de SiGe. Dans ce cas, il est possible que les premières grilles de commande électrostatique ne comportent pas le ou les premiers diélectriques de grille 114, et que la ou les portions de matériau électriquement conducteur 112 soi(en)t disposée(s) directement contre l'empilement de semi-conducteurs. La ou les interfaces entre l'empilement de semi-conducteurs et la ou les portions de matériau électriquement conducteur 112 des premières grilles de commande électrostatique forment dans ce cas des barrières Schottky, et la portion de semi-conducteur 102 comprenant les premières et deuxièmes régions 108, 110 correspond à la couche de l'hétérostructure dans laquelle se forme le gaz d'électrons bidimensionnel (2DEG). Des exemples de choix de matériaux métalliques et semi-conducteurs permettant la formation de barrières Schottky sont par exemple décrits dans les documents « The role of surface-gate technology for AIGaAs/GaAs nanostructures », R P Taylor 1994 Nanotechnology 5 183, et « High-mobility Si and Ge structures", Friedrich Schäffler 1997 Semicond. Sci. Technol. 12 1515.

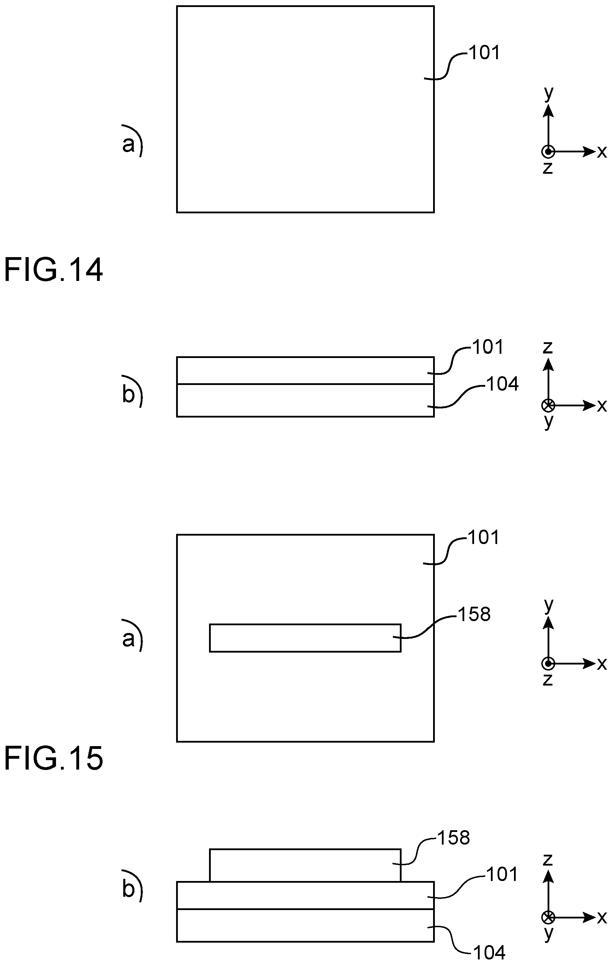

Un procédé de réalisation du dispositif 100 selon le premier mode de réalisation est décrit ci-dessous en lien avec les figures 14 à 26. Sur chacune de ces figures, une vue a) correspondant à une vue de dessus du dispositif 100 et une vue b) correspondant à une vue en coupe du dispositif 100 sont représentées.

Ledit procédé de réalisation n'est pas revendiqué mais il est utile pour comprendre l'invention.

Le dispositif 100 est réalisé à partir d'une couche de semi-conducteur 101 qui, dans l'exemple de réalisation décrit ici, correspond à la couche superficielle d'un substrat de type semi-conducteur sur isolant, et plus particulièrement de type SOI (figure 14). La couche 101 comporte du silicium et la couche diélectrique 104 comporte du SiO₂. L'épaisseur (dimension selon l'axe Z) de la couche 101 est par exemple comprise entre 10 nm et 25 nm.

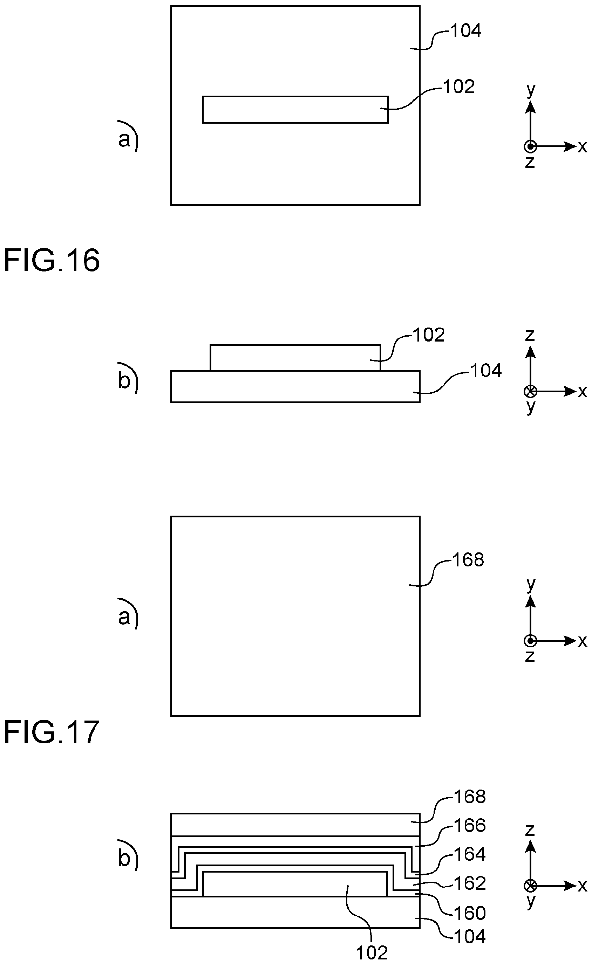

La couche 101 est ensuite gravée afin qu'au moins une portion restante 102 forme un nanofil dans lequel les boîtes quantiques du dispositif 100 seront réalisées. Pour cela, un premier masque de gravure 158, comportant par exemple une résine, est déposé sur la couche de semi-conducteur 101 (figure 15), puis une lithographie et une gravure sont mises en oeuvre afin que la portion restante 102 de semi-conducteur corresponde au nanofil dans lequel les boîtes quantiques du dispositif 100 seront réalisées (figure 16). Le premier masque de gravure 158 est ensuite retiré.

En variante, il est possible de ne pas mettre en oeuvre les étapes décrites ci-dessus en lien avec les figures 15 et 16, lorsque les boîtes quantiques du dispositif 100 sont réalisées directement dans la couche 101 comme c'est le cas dans le troisième mode de réalisation précédemment décrit.

Un empilement de couches de matériaux destinées à la réalisation des premières et deuxièmes grilles de commande électrostatique est ensuite déposé en recouvrant la portion 102 et le matériau diélectrique de la couche 104. Cet empilement comporte une première couche diélectrique 160 destinée à la réalisation des premiers diélectriques de grille 114, une première couche électriquement conductrice 162 destinée à la réalisation des premières portions de matériau électriquement conducteur 112, une deuxième couche diélectrique 164 destinée à la réalisation des deuxièmes diélectriques de grille 118, et une deuxième couche électriquement conductrice 166 destinée à la réalisation des deuxièmes portions de matériau électriquement conducteur 116. Afin de pouvoir graver cet empilement de couches 160, 162, 164, 166 et former les premières et deuxièmes grilles de commande électrostatique, une couche de masque dur 168, correspondant par exemple à une couche de SiN d'épaisseur égale à 30 nm, est déposée sur cet empilement (figure 17).

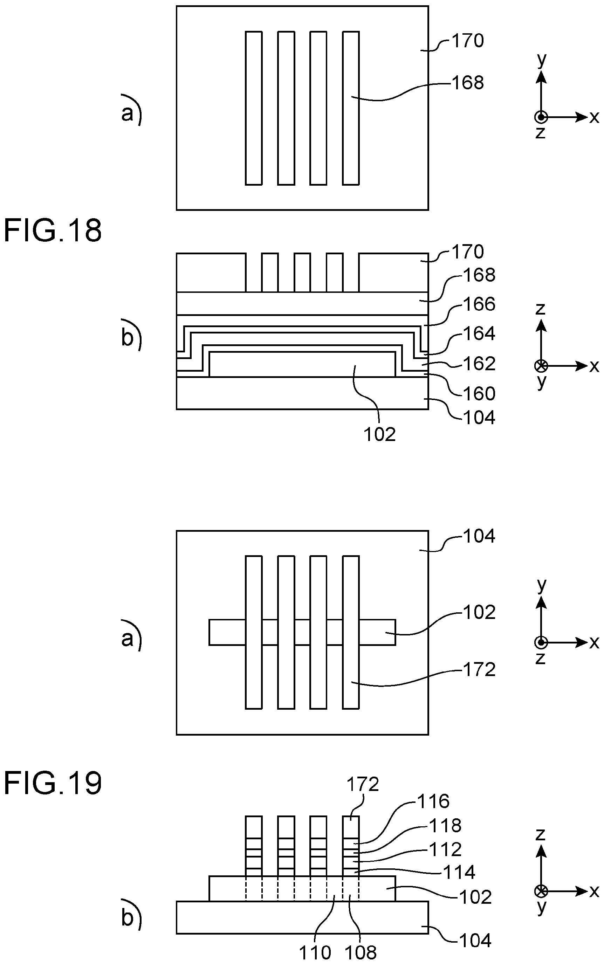

Un deuxième masque de gravure 170 est ensuite déposé sur la couche de masque dur 168, dont le motif correspond à celui les grilles de commande à réaliser (figure 18). La couche de masque dur 168 et l'empilement de couches 160, 162, 164, 166 sont ensuite soumis à une lithographie et une gravure selon le motif du deuxième masque de gravure 170. Les portions restantes de ces couches correspondent aux premières et deuxièmes portions de matériau électriquement conducteur 112, 116, aux premiers et deuxièmes diélectriques de grille 114, 118, et à des portions restantes de masque dur 172 (figure 19). La réalisation des premières et deuxièmes grilles de commande électrostatique définit également, dans la portion 102, les premières et deuxièmes régions 108, 110.

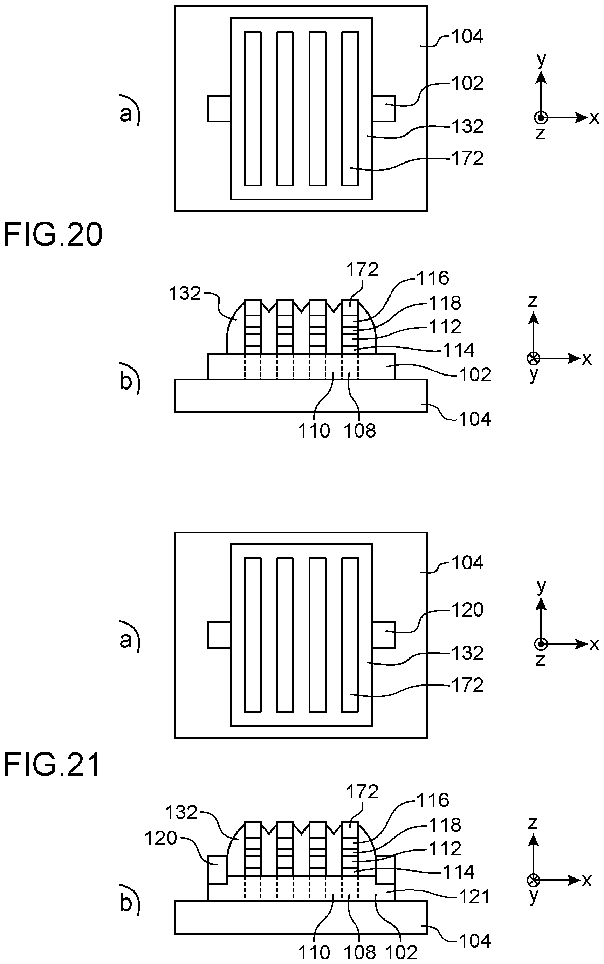

Les espaceurs diélectriques 132 sont ensuite réalisés en recouvrant les flancs latéraux des premières et deuxièmes grilles, ces flancs latéraux correspondant aux faces des premières et deuxièmes grilles qui sont perpendiculaires à la surface de la portion 102 sur laquelle les grilles sont réalisées. Sur l'exemple représenté sur la figure 20, les espaceurs diélectriques 132 recouvrent également les flancs latéraux des portions restantes de masque dur 172.

Comme représenté sur la figure 21, les réservoirs 120 de porteurs de charges sont réalisés par épitaxie sur les extrémités 121 de la portion 102, avec un dopage *in situ* des portions de semi-conducteur formant les réservoirs 120. En variante, les réservoirs de porteurs de charge peuvent être réalisés par implantation de dopants directement dans les extrémités 121 de la portion 102 non recouvertes par les premières et deuxièmes grilles et par les espaceurs diélectriques 132.

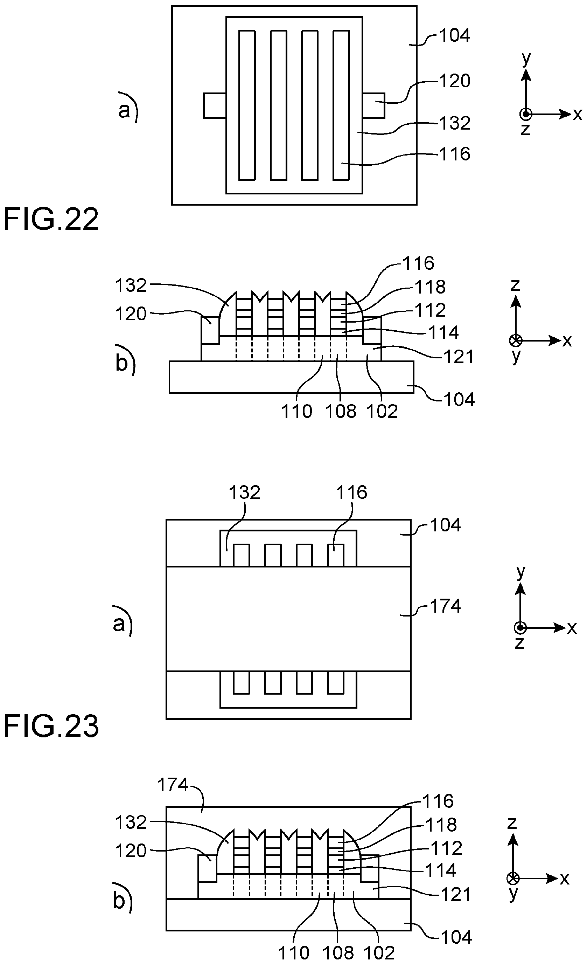

Les portions restantes de masque dur 172 sont ensuite retirées (figure 22).

Un troisième masque 174 est ensuite réalisé de manière à recouvrir les deuxièmes portions 116, excepté les régions recouvrant les premières et deuxièmes extrémités 122, 124 des premières portions 122 au niveau desquelles les premiers contacts électriquement conducteurs 126 sont destinés à être réalisés (figure 23).

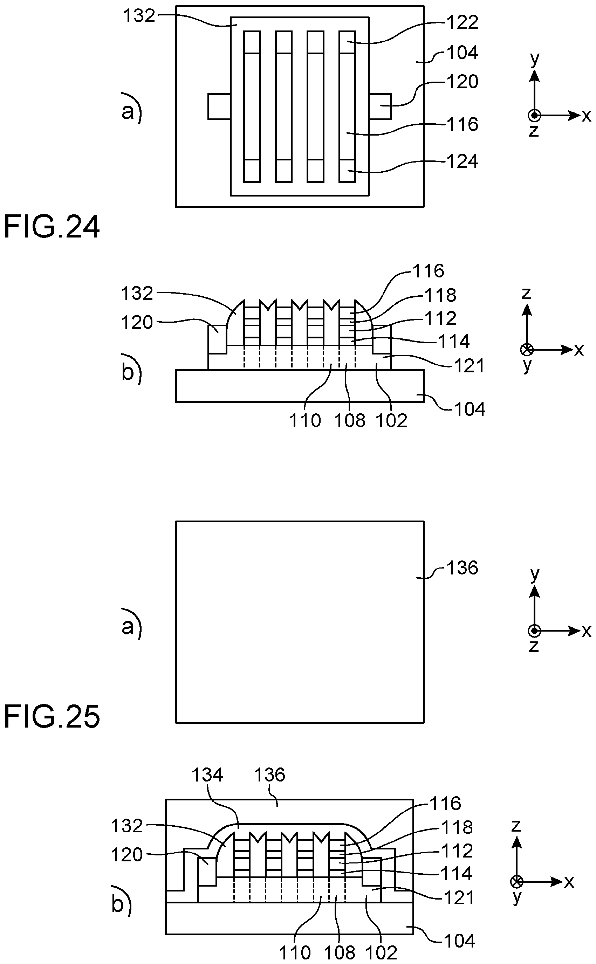

Les parties des deuxièmes portions 116 et du deuxième diélectrique de grille 118 non recouvertes par le troisième masque 174 sont ensuite gravées, révélant ainsi les premières et deuxièmes extrémités 122, 124 des premières portions 112. Le troisième masque 174 est ensuite retiré (figure 24).

Une couche d'arrêt à la gravure 134 et un matériau diélectrique pré-métal 136 sont ensuite déposés puis planarisés (voir figure 25).

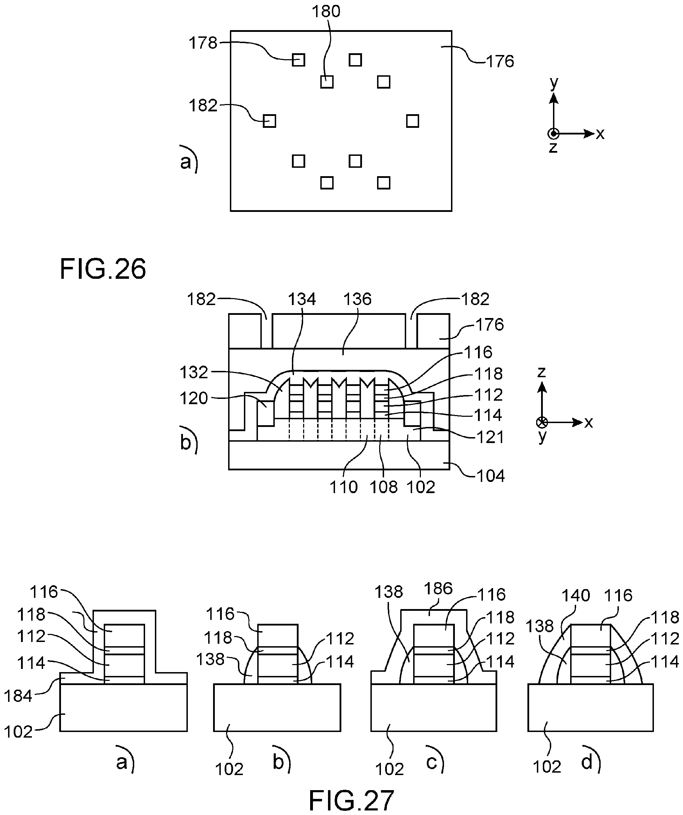

Un quatrième masque 176 est ensuite réalisé sur la structure réalisée, dans lequel les ouvertures définissent les emplacements des contacts électriques du dispositif 100 : des premières ouvertures 178 définissent les emplacements des premiers contacts 126, des deuxièmes ouvertures 180 définissent les emplacements des deuxièmes contacts 128, et des troisièmes ouvertures 182 définissent les emplacements des troisièmes contacts 130 (voir figure 26).

Le dispositif 100 est ensuite achevé en gravant le matériau diélectrique de pré-métal 136 et la couche d'arrêt à la gravure 134 à l'aplomb des ouvertures 178, 180 et 182 du quatrième masque 176, formant ainsi les emplacements des premiers, deuxièmes et troisièmes contacts 126, 128, 130, puis en déposant au moins un matériau électriquement conducteur dans ces emplacements et en planarisant le matériau électriquement conducteur, formant ainsi les premiers, deuxièmes et troisièmes contacts 126, 128, 130. Le quatrième masque 176 est ensuite retiré. Le dispositif obtenu à l'issue de ce procédé correspond à celui représenté sur les figures 1 et 2.

Dans le procédé précédemment décrit, les espaceurs diélectriques 132 sont réalisés en déposant un seul matériau diélectrique. Pour réaliser des espaceurs diélectriques 132 tels que précédemment décrits en lien avec la figure 6, c'est-à-dire tels qu'ils comportent au moins un premier matériau diélectrique recouvrant les flancs latéraux des premières portions 112 et au moins un deuxième matériau diélectrique, différent du premier matériau diélectrique, recouvrant les flancs latéraux des deuxièmes portions 116, les étapes décrites ci-dessous en lien avec la figure 27 sont par exemple mises en œuvre.

Comme représenté sur la vue a) de la figure 27, une couche 184 comportant le premier matériau diélectrique est déposée de manière conforme en recouvrant les premières et deuxièmes grilles de contrôle.

Cette couche 184 est ensuite gravée afin que les portions restantes forment les premières parties 138 qui recouvrent les flancs latéraux des premières portions 112 et des premiers diélectriques de grille 114 (vue b) de la figure 27).

Une couche 186 comportant le deuxième matériau diélectrique est ensuite déposée de manière conforme (vue c) de la figure 27), puis gravée afin les portions restantes de cette couche forment les deuxièmes parties 140 qui recouvrent les flancs latéraux des deuxièmes portions 116 et des deuxièmes diélectriques de grille 118 (vue d) de la figure 27).

Dans les modes de réalisation et variantes décrits précédemment, le dispositif 100 comporte plusieurs qubits de spin chacun codé par un électron stocké dans une boîte quantique. En variante, il est possible que chaque qubit soit codé par plusieurs électrons stockés dans plusieurs boîtes quantiques voisines, par exemple des doubles ou triples boîtes quantiques.

Dans les différents modes de réalisation et variantes décrits précédemment, le dispositif 100 correspond à un dispositif quantique à qubits de spin. Ces différents modes de réalisation et variantes peuvent toutefois être appliqués pour un dispositif 100 ne correspondant pas à un dispositif quantique et utilisé dans un mode de fonctionnement semblable à celui de transistors à effet de champ couplés en série. Un tel dispositif 100 peut fonctionner dans un environnement cryogénique, c'est-à-dire dans un cryostat à des températures cryogéniques (inférieures à 1 K, voire inférieures à 4 K). Dans un tel mode de fonctionnement, les grilles de commande électrostatique du dispositif 100 sont utilisées comme des grilles de transistors classiques, dont les polarisations contrôlent la conductance entre les régions 121 de la structure.

## Revendications

1. Dispositif quantique (100) comportant au moins :
- une portion de semi-conducteur (101, 102) comprenant plusieurs premières régions (108) configurées pour former des boîtes quantiques d'au moins un qubit de spin du dispositif quantique (100), chacune disposée entre au moins deux deuxièmes régions (110) configurées pour former des barrières tunnel et juxtaposée aux deux deuxièmes régions (110) ;
- des premières grilles de commande électrostatique comprenant chacune au moins une première portion de matériau électriquement conducteur (112) ;
- des deuxièmes grilles de commande électrostatique comprenant chacune au moins une deuxième portion de matériau électriquement conducteur (116) et au moins un deuxième diélectrique de grille (118) disposé entre la deuxième portion de matériau électriquement conducteur (116) et la première portion de matériau électriquement conducteur (112) de l'une des premières grilles de commande électrostatique, telles que chacune des premières grilles de commande électrostatique soit disposée entre la portion de semi-conducteur (101, 102) et l'une des deuxièmes grilles de commande électrostatique ;
dans lequel les deuxièmes grilles de commande électrostatique sont uniquement situées dans un prolongement, perpendiculairement au plan principal de la portion de semi-conducteur (101, 102), des premières grilles de commande électrostatique ;
et dans lequel, dans une première configuration, les premières et deuxièmes grilles de commande électrostatique sont disposées au-dessus des premières régions (108) de la portion de semi-conducteur (101, 102), les deuxièmes régions (110) de la portion de semi-conducteur (101, 102) n'étant pas recouvertes par lesdites premières et deuxièmes grilles de commande électrostatique, ou dans lequel, dans une deuxième configuration, les premières et deuxièmes grilles de commande électrostatique sont disposées au-dessus des deuxièmes régions (110) de la portion de semi-conducteur (101, 102), les premières régions (108) de la portion de semi-conducteur (101, 102) n'étant
pas recouvertes par lesdites premières et deuxièmes grilles de commande électrostatique.

2. Dispositif (100) selon la revendication 1, dans lequel :
- chacune des premières grilles de commande électrostatique comporte en outre au moins un premier diélectrique de grille (114) disposé entre la portion de semi-conducteur (101, 102) et la première portion de matériau électriquement conducteur (112) de ladite première grille de commande électrostatique, ou
- le dispositif comporte un empilement de plusieurs semi-conducteurs différents formant une hétérostructure et incluant la portion de semi-conducteur, et tel que des interfaces entre l'empilement de plusieurs semi-conducteurs et les premières portions de matériau électriquement conducteur (112) des premières grilles de commande électrostatique forment des barrières Schottky, ou
- chacune des premières grilles de commande électrostatique comporte en outre au moins un premier diélectrique de grille disposé entre un empilement de plusieurs semi-conducteurs et la première portion de matériau électriquement conducteur, l'empilement de plusieurs semi-conducteurs comportant des semi-conducteurs différents formant une hétérostructure.

3. Dispositif (100) selon l'une des revendications précédentes, dans lequel le semi-conducteur des premières et deuxièmes régions (108, 110) est non intentionnellement dopé.

4. Dispositif (100) selon l'une des revendications précédentes, comportant en outre des réservoirs (120) de porteurs de charges électriques entre lesquels les premières et deuxièmes régions (108, 110) de la portion de semi-conducteur (101, 102) sont disposées.

5. Dispositif (100) selon l'une des revendications précédentes, comportant en outre des moyens d'application d'au moins un premier potentiel électrique sur chacune des premières portions de matériau électriquement conducteur (112) et d'au moins un deuxième potentiel électrique, de valeur indépendante de celle du premier potentiel électrique, sur chacune des deuxièmes portions de matériau électriquement conducteur (116).

6. Dispositif (100) selon l'une des revendications précédentes, dans lequel
chacune des premières grilles de commande électrostatique comporte en outre au moins un premier diélectrique de grille (114) disposé entre la portion de semi-conducteur (101, 102) et la première portion de matériau électriquement conducteur (112) de ladite première grille de commande électrostatique, et dans lequel
les premières et deuxièmes régions (108, 110) de la portion de semi-conducteur (101, 102) sont alignées selon une première direction parallèle au plan principal de la portion de semi-conducteur (101, 102), et :
- une dimension, parallèle à la première direction, d'au moins l'une des premières portions de matériau électriquement conducteur (112) est inférieure à une dimension, parallèle à la première direction, de la deuxième portion de matériau électriquement conducteur (116) disposée sur ladite au moins une des premières portions de matériau électriquement conducteur (112), ou
- une dimension, parallèle à la première direction, d'au moins l'une des deuxièmes portions de matériau électriquement conducteur (116) est inférieure à une dimension, parallèle à la première direction, de la première portion de matériau électriquement conducteur (112) disposée sous ladite au moins une des deuxièmes portions de matériau électriquement conducteur (116).

7. Dispositif (100) selon la revendication 6, dans lequel :
- chacune des premières et deuxièmes portions de matériau électriquement conducteur (112, 116) comporte une plus grande dimension s'étendant selon une deuxième direction perpendiculaire à la première direction, et
- au moins une extrémité (122, 124) de chacune des premières portions de matériau électriquement conducteur (112) n'est pas recouverte par la deuxième portion de matériau électriquement conducteur (116) disposée sur ladite première portion de matériau électriquement conducteur (112), et
- chacune des premières portions de matériau électriquement conducteur (112) est couplée électriquement à un premier contact électriquement conducteur (126) réalisé sur ladite extrémité (122, 124) de chacune des premières portions de matériau électriquement conducteur (112), et
- chacune des deuxièmes portions de matériau électriquement conducteur (116) est couplée électriquement à un deuxième contact électriquement conducteur (128) réalisé sur la deuxième portion de matériau électriquement conducteur (116).

8. Dispositif (100) selon la revendication 7, dans lequel :
- des première et deuxième extrémités (122, 124) de chacune des premières portions de matériau électriquement conducteur (112) ne sont pas recouvertes par la deuxième portion de matériau électriquement conducteur (116) disposée sur ladite première portion de matériau électriquement conducteur (112), et
- chacune des premières portions de matériau électriquement conducteur (112) est couplée électriquement à un premier contact électriquement conducteur (126) réalisé sur l'une des première et deuxième extrémités (122, 124) de chacune des premières portions de matériau électriquement conducteur (112), et deux des premiers contacts électriquement conducteurs (126) couplés électriquement à deux des premières portions de matériau électriquement conducteur (112) disposées côte à côte sont tels que l'un desdits deux premiers contacts électriquement conducteurs (126) soit réalisé sur la première extrémité (122) de l'une desdites deux des premières portions de matériau électriquement conducteur (112) et que l'autre desdits deux premiers contacts électriquement conducteurs (126) soit réalisé sur la deuxième extrémité (124) de l'autre desdites deux des premières portions de matériau électriquement conducteur (112).

9. Dispositif (100) selon l'une des revendications précédentes, dans lequel la portion de semi-conducteur (102) correspond à un nanofil de semi-conducteur.

10. Dispositif (100) selon la revendication 9, dans lequel :
- la portion de semi-conducteur (102) comporte une face supérieure, une face inférieure et des faces latérales sensiblement perpendiculaires aux faces supérieure et inférieure ;
- chacune des premières et deuxièmes grilles de commande recouvre partiellement au moins une des première et deuxième arrêtes supérieures (146, 148) de la portion de semi-conducteur (102) formées aux jonctions entre la face supérieure et des première et deuxième faces latérales opposées l'une de l'autre et parallèle à la plus grande dimension de la portion de semi-conducteur (102).

11. Dispositif (100) selon la revendication 10, dans lequel :
- plusieurs des premières et deuxièmes grilles de commande recouvrent partiellement la première arrête supérieure (146) et les autres premières et deuxièmes grilles de commande recouvrent partiellement la deuxième arrête supérieure (148), chacune des premières et deuxièmes grilles de commande recouvrant partiellement la première arrête supérieure (146) étant disposée en regard d'une première et d'une deuxième grille de commande recouvrent partiellement la deuxième arrête supérieure (148) ;
et comportant en outre une troisième grille de commande électrostatique comprenant au moins une troisième portion de matériau électriquement conducteur (150) disposée en regard d'au moins une quatrième région (152) de la portion de semi-conducteur (102) non recouverte par les premières et deuxièmes grilles de commande électrostatique.

12. Dispositif (100) selon l'une des revendications 1 à 8, dans lequel les premières régions (108) de la portion de semi-conducteur (101) sont agencées sous la forme d'une matrice bidimensionnelle, plusieurs des premières et deuxièmes grilles de commande électrostatique étant agencées sous la forme de lignes (154) et les autres premières et deuxièmes grilles de commande étant agencées sous la forme de colonnes (156).

13. Dispositif (100) selon l'une des revendications précédentes, comportant en outre des espaceurs diélectriques (132) recouvrant des flancs latéraux des premières et deuxièmes grilles de commande électrostatique, et disposés, dans la première configuration, au-dessus des deuxièmes régions (110) de la portion de semi-conducteur (101, 102), ou, dans la deuxième configuration, au-dessus des première régions (108) de la portion de semi-conducteur (101, 102).

14. Dispositif (100) selon la revendication 13, dans lequel les espaceurs diélectriques (132) comportent au moins un premier matériau diélectrique (138) recouvrant les flancs latéraux des premières portions de matériau électriquement conducteur (112) et au moins un deuxième matériau diélectrique (140) recouvrant les flancs latéraux des deuxièmes portions de matériau électriquement conducteur (116), la permittivité du premier matériau diélectrique (138) étant inférieure à celle du deuxième matériau diélectrique (140).

15. Dispositif (100) selon l'une des revendications précédentes, dans lequel le deuxième diélectrique de grille (118) repose uniquement sur les premières portions de matériau électriquement conducteur (112), ou uniquement sur les premières portions de matériau électriquement conducteur (112) et une partie d'espaceurs latéraux (132) disposés contre les premières portions de matériau électriquement conducteur (112).

## Patentansprüche

1. Quantenvorrichtung (100), die mindestens umfasst:
- einen Halbleiterabschnitt (101, 102), der mehrere erste Bereiche (108) umfasst, die so konfiguriert sind, dass sie Quantenpunkte mindestens eines Spin-Qubits der Quantenvorrichtung (100) bilden, die jeweils zwischen mindestens zwei zweiten Bereichen (110), welche so konfiguriert sind, dass sie Tunnelbarrieren bilden, angeordnet sind und an die zwei zweiten Bereiche (110) angrenzen;
- erste elektrostatische Steuergates, die jeweils mindestens einen ersten Abschnitt aus elektrisch leitendem Material (112) umfassen;
- zweite elektrostatische Steuergates, die jeweils mindestens einen zweiten Abschnitt aus elektrisch leitendem Material (116) und mindestens ein zweites Gate-Dielektrikum (118) umfassen, das zwischen dem zweiten Abschnitt aus elektrisch leitendem Material (116) und dem ersten Abschnitt aus elektrisch leitendem Material (112) eines der ersten elektrostatischen Steuergates angeordnet ist, sodass jedes der ersten elektrostatischen Steuergates zwischen dem Halbleiterabschnitt (101, 102) und einem der zweiten elektrostatischen Steuergates angeordnet ist;
wobei die zweiten elektrostatischen Steuergates sich nur in einer senkrecht zur Hauptebene des Halbleiterabschnitts (101, 102) stehenden Verlängerung der ersten elektrostatischen Steuergates befinden;
und wobei in einer ersten Konfiguration die ersten und zweiten elektrostatischen Steuergates über den ersten Bereichen (108) des Halbleiterabschnitts (101, 102) angeordnet sind, wobei die zweiten Bereiche (110) des Halbleiterabschnitts (101, 102) nicht von den ersten und zweiten elektrostatischen Steuergates bedeckt sind, oder wobei in einer zweiten Konfiguration die ersten und zweiten elektrostatischen Steuergates über den zweiten Bereichen (110) des Halbleiterabschnitts (101, 102) angeordnet sind, wobei die ersten Bereiche (108) des Halbleiterabschnitts (101, 102) nicht von den ersten und zweiten elektrostatischen Steuergates bedeckt sind.

2. Vorrichtung (100) nach Anspruch 1, wobei:
- jedes der ersten elektrostatischen Steuergates weiter mindestens ein erstes Gate-Dielektrikum (114) umfasst, das zwischen dem Halbleiterabschnitt (101, 102) und dem ersten Abschnitt aus elektrisch leitendem Material (112) des ersten elektrostatischen Steuergates angeordnet ist, oder
- die Vorrichtung einen Stapel aus mehreren unterschiedlichen Halbleitern, der eine Heterostruktur bildet und den Halbleiterabschnitt beinhaltet, und so umfasst, dass Grenzflächen zwischen dem Stapel aus mehreren Halbleitern und den ersten Abschnitten aus elektrisch leitendem Material (112) der ersten elektrostatischen Steuergates Schottky-Barrieren bilden, oder
- jedes der ersten elektrostatischen Steuergates weiter mindestens ein erstes Gate-Dielektrikum umfasst, das zwischen einem Stapel aus mehreren Halbleitern und dem ersten Abschnitt aus elektrisch leitendem Material angeordnet ist, wobei der Stapel aus mehreren Halbleitern unterschiedliche Halbleiter umfasst, die eine Heterostruktur bilden.

3. Vorrichtung (100) nach einem der vorstehenden Ansprüche, wobei der Halbleiter des ersten und des zweiten Bereichs (108, 110) nicht absichtlich dotiert ist.

4. Vorrichtung (100) nach einem der vorstehenden Ansprüche, die weiter Reservoirs (120) für elektrische Ladungsträger umfasst, zwischen denen die ersten und zweiten Bereiche (108, 110) des Halbleiterabschnitts (101, 102) angeordnet sind.

5. Vorrichtung (100) nach einem der vorstehenden Ansprüche, die weiter Mittel zum Anlegen mindestens eines ersten elektrischen Potentials an jeden der ersten Abschnitte aus elektrisch leitendem Material (112), und mindestens eines zweiten elektrischen Potentials mit einem von dem des ersten elektrischen Potentials unabhängigem Wert an jeden der zweiten Abschnitte aus elektrisch leitendem Material (116) umfasst.

6. Vorrichtung (100) nach einem der vorstehenden Ansprüche, wobei jedes der ersten elektrostatischen Steuergates weiter mindestens ein erstes Gate-Dielektrikum (114) umfasst, das zwischen dem Halbleiterabschnitt (101, 102) und dem ersten Abschnitt aus elektrisch leitendem Material (112) des ersten elektrostatischen Steuergates angeordnet ist, und wobei
die ersten und zweiten Bereiche (108, 110) des Halbleiterabschnitts (101, 102) in einer ersten Richtung parallel zur Hauptebene des Halbleiterabschnitts (101, 102) ausgerichtet sind, und:
- eine zur ersten Richtung parallele Abmessung mindestens eines der ersten Abschnitte aus elektrisch leitendem Material (112) kleiner ist als eine zur ersten Richtung parallele Abmessung des zweiten Abschnitts aus elektrisch leitendem Material (116), der auf dem mindestens einen der ersten Abschnitte aus elektrisch leitendem Material (112) angeordnet ist, oder
- eine zur ersten Richtung parallele Abmessung mindestens eines der zweiten Abschnitte aus elektrisch leitendem Material (116) kleiner ist als eine zur ersten Richtung parallele Abmessung des ersten Abschnitts aus elektrisch leitendem Material (112), der unter dem mindestens einen der zweiten Abschnitte aus elektrisch leitendem Material (116) angeordnet ist.

7. Vorrichtung (100) nach Anspruch 6, wobei:
- jeder der ersten und zweiten Abschnitte aus elektrisch leitendem Material (112, 116) eine größere Abmessung umfasst, die sich in einer zweiten Richtung senkrecht zur ersten Richtung erstreckt, und
- mindestens ein Ende (122, 124) jedes der ersten Abschnitte aus elektrisch leitendem Material (112) nicht von dem zweiten Abschnitt aus elektrisch leitendem Material (116), der auf dem ersten Abschnitt aus elektrisch leitendem Material (112) angeordnet ist, bedeckt ist, und
- jeder der ersten Abschnitte aus elektrisch leitendem Material (112) elektrisch mit einem ersten elektrisch leitenden Kontakt (126) gekoppelt ist, der am Ende (122, 124) jedes der ersten Abschnitte aus elektrisch leitendem Material (112) hergestellt ist, und
- jeder der zweiten Abschnitte aus elektrisch leitendem Material (116) elektrisch mit einem zweiten elektrisch leitenden Kontakt (128) gekoppelt ist, der am zweiten Abschnitt aus elektrisch leitendem Material (116) hergestellt ist.

8. Vorrichtung (100) nach Anspruch 7, wobei:
- ein erstes und ein zweites Ende (122, 124) jedes der ersten Abschnitte aus elektrisch leitendem Material (112) nicht von dem zweiten Abschnitt aus elektrisch leitendem Material (116), der auf dem ersten Abschnitt aus elektrisch leitendem Material (112) angeordnet ist, bedeckt sind, und
- jeder der ersten Abschnitte aus elektrisch leitendem Material (112) elektrisch mit einem ersten elektrisch leitenden Kontakt (126), der an einem des ersten und zweiten Endes (122, 124) jedes der ersten Abschnitte aus elektrisch leitendem Material (112) hergestellt ist, gekoppelt ist, und zwei der ersten elektrisch leitenden Kontakte (126), die elektrisch mit zwei nebeneinander angeordneten der ersten Abschnitte aus elektrisch leitendem Material (112), gekoppelt sind, so sind, dass einer der zwei ersten elektrisch leitenden Kontakte (126) am ersten Ende (122) eines der zwei der ersten Abschnitte aus elektrisch leitendem Material (112) hergestellt ist, und dass der andere der zwei ersten elektrisch leitenden Kontakte (126) am zweiten Ende (124) des anderen der zwei der ersten Abschnitte aus elektrisch leitendem Material (112) hergestellt ist.

9. Vorrichtung (100) nach einem der vorstehenden Ansprüche, wobei der Halbleiterabschnitt (102) einem Halbleiter-Nanodraht entspricht.

10. Vorrichtung (100) nach Anspruch 9, wobei:
- der Halbleiterabschnitt (102) eine obere Fläche, eine untere Fläche und seitliche Flächen umfasst, die im Wesentlichen senkrecht zur oberen und unteren Fläche stehen;
- jedes der ersten und zweiten Steuergates teilweise mindestens eine der ersten und der zweiten oberen Kante (146, 148) des Halbleiterabschnitts (102) bedeckt, welche an den Übergängen zwischen der oberen Fläche und einer ersten und zweiten seitlichen Fläche, die einander gegenüberliegen und parallel zur größten Abmessung des Halbleiterabschnitts (102) verlaufen, gebildet werden.

11. Vorrichtung (100) nach Anspruch 10, wobei:
- mehrere der ersten und zweiten Steuergates teilweise die erste obere Kante (146) bedecken, und die anderen ersten und zweiten Steuergates teilweise die zweite obere Kante (148) bedecken, wobei jedes der ersten und zweiten Steuergates, die teilweise die erste obere Kante (146) bedecken, einem ersten und einem zweiten Steuergate, die teilweise die zweite obere Kante (148) bedecken, zugewandt angeordnet ist;
und weiter ein drittes elektrostatisches Steuergate umfassend, das mindestens einen dritten Abschnitt aus elektrisch leitendem Material (150) umfasst, der mindestens einem vierten Bereich (152) des Halbleiterabschnitts (102), welcher nicht von den ersten und zweiten elektrostatischen Steuergates bedeckt ist, zugewandt angeordnet ist.

12. Vorrichtung (100) nach einem der Ansprüche 1 bis 8, wobei die ersten Bereiche (108) des Halbleiterabschnitts (101) in Form einer zweidimensionalen Matrix eingerichtet sind, wobei mehrere der ersten und zweiten elektrostatischen Steuergates in Form von Zeilen (154) eingerichtet sind, und die anderen ersten und zweiten Steuergates in Form von Spalten (156) eingerichtet sind.

13. Vorrichtung (100) nach einem der vorstehenden Ansprüche, die weiter dielektrische Abstandshalter (132) umfasst, die seitliche Flanken der ersten und zweiten elektrostatischen Steuergates bedecken und in der ersten Konfiguration über den zweiten Bereichen (110) des Halbleiterabschnitts (101, 102) oder in der zweiten Konfiguration über den ersten Bereichen (108) des Halbleiterabschnitts (101, 102) angeordnet sind.

14. Vorrichtung (100) nach Anspruch 13, wobei die dielektrischen Abstandshalter (132) mindestens ein erstes dielektrisches Material (138), das die seitlichen Flanken der ersten Abschnitte aus elektrisch leitendem Material (112) bedeckt, und mindestens ein zweites dielektrisches Material (140) umfassen, das die seitlichen Flanken der zweiten Abschnitte aus elektrisch leitendem Material (116) bedeckt, wobei die Permittivität des ersten dielektrischen Materials (138) kleiner ist als die des zweiten dielektrischen Materials (140).

15. Vorrichtung (100) nach einem der vorstehenden Ansprüche, wobei das zweite Gate-Dielektrikum (118) nur auf den ersten Abschnitten aus elektrisch leitendem Material (112) oder nur auf den ersten Abschnitten aus elektrisch leitendem Material (112) und einem Teil seitlicher Abstandshalter (132), die an den ersten Abschnitten aus elektrisch leitendem Material (112) angeordnet sind, aufliegt.

## Claims

1. Quantum device (100) including at least:
- a semiconductor portion (101, 102) comprising several first regions (108) configured to form quantum dots of at least one spin qubit of the quantum device (100), each disposed between at least two second regions (110) forming tunnel barriers and juxtaposed with the two second regions (110);
- first electrostatic control gates each comprising at least a first portion of electrically conductive material (112);
- second electrostatic control gates each comprising at least a second portion of electrically conductive material (116) and at least a second gate dielectric (118) disposed between the second portion of electrically conductive material (116) and the first portion of electrically conductive material (112) of one of the first electrostatic control gates, such that each of the first electrostatic control gates is disposed between the semiconductor portion (101, 102) and one of the second electrostatic control gates;
wherein the second electrostatic control gates are solely located in the vertical extension, perpendicular to the main plane of the semiconductor portion (101, 102), of the first electrostatic control gates;
and wherein, in a first configuration, the first and second electrostatic control gates are disposed above the first regions (108) of the semiconductor portion (101, 102), the second regions (110) of the semiconductor portion (101, 102) not being covered by the first and second electrostatic control gates,
or wherein, in a second configuration, the first and second electrostatic control gates are disposed above the second regions (110) of the semiconductor portion (101, 102), the first regions (108) of the semiconductor portion (101, 102) not being covered by the first and second electrostatic control gates.

2. Device (100) according to claim 1, wherein:
- each of the first electrostatic control gates further includes at least a first gate dielectric (114) disposed between the semiconductor portion (101, 102) and the first portion of electrically conductive material (112) of said first electrostatic control gate, or
- the device includes a stack of several different semiconductors forming a heterostructure and including the semiconductor portion, and such that interfaces between the stack of several semiconductors and the first portions of electrically conductive material (112) of the first electrostatic control gates form Schottky barriers, or
- each of the first electrostatic control gates further includes at least a first gate dielectric disposed between a stack of several semiconductors and the first portion of electrically conductive material, the stack of several semiconductors including different semiconductors forming a heterostructure, such that interfaces between the stack of several semiconductors and the at least a first gate dielectric of the first electrostatic control gates form Schottky barriers.

3. Device (100) according to any of the preceding claims, wherein the semiconductor of the first and second regions (108, 110) is unintentionally doped.

4. Device (100) according to any of the preceding claims, further including electrical charge carrier reservoirs (120) between which the first and second regions (108, 110) of the semiconductor portion (101, 102) are disposed.

5. Device (100) according to any of the preceding claims, further including means for applying at least a first electric potential to each of the first portions of electrically conductive material (112) and at least a second electric potential, of a separate value from that of the first electric potential, to each of the second portions of electrically conductive material (116).

6. Device according to any of the preceding claims, wherein each of the first electrostatic control gates further comprises at least one first gate dielectric (114) disposed between the semiconductor portion (101, 102) and the first electrically conductive material portion (112) of said first electrostatic control gate, and wherein the first regions (108, 110) of the semiconductor portion (101, 102) are aligned in a first direction parallel to the main plane of the semiconductor portion (101, 102),
- a dimension, parallel with the first direction, of at least one of the first portions of electrically conductive material (112) is less than a dimension, parallel with the first direction, of the second portion of electrically conductive material (116) disposed on said at least one of the first portions of electrically conductive material (112), or
- a dimension, parallel with the first direction, of at least one of the second portions of electrically conductive material (116) is less than a dimension, parallel with the first direction, of the first portion of electrically conductive material (112) disposed under said at least one of the second portions of electrically conductive material (116).

7. Device (100) according to claim 6, wherein:
- each of the first and second portions of electrically conductive material (112, 116) includes a greater dimension extending along a second direction perpendicular to the first direction, and
- at least one end (122, 124) of each of the first portions of electrically conductive material (112) is not covered by the second portion of electrically conductive material (1) disposed on said first portion of electrically conductive material (112), and
- each of the first portions of electrically conductive material (112) is electrically coupled with a first electrically conductive contact (126) produced on said end (122, 124) of each of the first portions of electrically conductive material (112), and
- each of the second portions of electrically conductive material (116) is electrically coupled with a second electrically conductive contact (128) produced on the second portion of electrically conductive material (116).

8. Device (100) according to claim 7, wherein:
- first and second ends (122, 124) of each of the first portions of electrically conductive material (112) are not covered by the second portion of electrically conductive material (116) disposed on said first portion of electrically conductive material (112), and
- each of the first portions of electrically conductive material (112) is electrically coupled with a first electrically conductive contact (126) produced on one of the first and second ends (122, 124) of each of the first portions of electrically conductive material (112), and two of the first electrically conductive contacts electrically coupled with two of the first portions of electrically conductive material (112) disposed side by side are such that one of said two first electrically conductive contacts (126) is produced on the first end of one of said two of the first portions of electrically conductive material (112) and the other of said two first electrically conductive contacts (126) is produced on the second end (124) of the other of said two of the first portions of electrically conductive material (112).

9. Device (100) according to one of the preceding claims, wherein the semiconductor portion (102) corresponds to a semiconductor nanowire.

10. Device according to claim 9, wherein:
- the semiconductor portion (102) includes a top face, a bottom face and lateral faces substantially perpendicular to the top and bottom faces;
- each of the first and second control gates partially covers at least one of the first and second top edges (146, 148) of the semiconductor portion (102) formed at the junctions between the top face and the first and second lateral faces opposite one another and parallel with the greatest dimension of the semiconductor portion (102).

11. Device (100) according to claim 10, wherein:
- several of the first and second control gates partially cover the first top edge (146) and the other first and second control gates partially cover the second top edge (148), each of the first and second control gates partially covering the first top edge (146) being disposed facing a first and a second control gate partially covering the second top edge (148);
and further including a third electrostatic control gate comprising at least a third portion of electrically conductive material (150) disposed facing at least a fourth region (152) of the semiconductor portion (102) not covered by the first and second electrostatic control gates.

12. Device (100) according to any of the claims 1 to 8, wherein the first regions (108) of the semiconductor portion (101) are arranged in the form of a two-dimensional array, several of the first and second electrostatic control gates being arranged in the form of rows (154) and the other first and second control gates being arranged in the form of columns (156).

13. Device (100) according to any of the preceding claims, further including dielectric spacers (132) covering lateral sides of the first and second electrostatic control gates, and disposed, in the first configuration, above the second regions (110) of the semiconductor portion (101, 102), or, in the second configuration, above the first regions (108) of the semiconductor portion (101, 102).

14. Device (100) according to claim 13, wherein the dielectric spacers (132) include at least a first dielectric material (138) covering the lateral sides of the first portions of electrically conductive material (112) and at least a second dielectric material (140) covering the lateral sides of the second portions of electrically conductive material (116), the permittivity of the first dielectric material (138) being less than that of the second dielectric material (140).

15. Device according to any of the preceding claims, wherein the second gate dielectric (118) rests solely on the first portions of electrically conductive material (112), or solely on the first portions of electrically conductive material (112) and a part of lateral spacers (132) disposed against the first portions of electrically conductive material (112).
